# EUROPEAN PATENT APPLICATION

(11) **EP 4 071 554 A1**
(43) Date of publication of application: **12.10.2022**
(21) Application number: 21167479.1
(22) Date of filing: 08.04.2021
(51) Int. Cl.: G03F 7/20, G03F 9/00

(54) **A METHOD FOR MODELING MEASUREMENT DATA OVER A SUBSTRATE AREA AND ASSOCIATED APPARATUSES**

(71) Applicant: ASML Netherlands B.V., 5500 AH Veldhoven (NL)
(72) Inventor: KARA, Dogacan, 5500 AH Veldhoven (NL); WILDENBERG, Jochem Sebastiaan, 5500 AH Veldhoven (NL); DECKERS, David Frans Simon, 5500 AH Veldhoven (NL); YUDHISTIRA, Yasri, 5500 AH Veldhoven (NL); HILHORST, Gijs, 5500 AH Veldhoven (NL); CAICEDO FERNANDEZ, David Ricardo, 5500 AH Veldhoven (NL); SPIERING, Frans Reinier, 5500 AH Veldhoven (NL); KHO, Sinatra Canggih, 5500 AH Veldhoven (NL); BLOM, Herman Martin, 5500 AH Veldhoven (NL); KIM, Sang-Uk, 5500 AH Veldhoven (NL); KIM, Hyun Su, 5500 AH Veldhoven (NL)
(74) Representative: ASML Netherlands B.V.

(57) **Abstract**

Disclosed is a method for modeling measurement data relating to a parameter of interest over at least two substrate portions of a substrate and associated apparatuses. The method comprises obtaining at least a first substrate portion model for describing the parameter of interest across one or more first substrate portions on the substrate and a second substrate portion model for describing the parameter of interest across one or more second substrate portions on the substrate; and performing steps 1 to 4 iteratively for each of said plurality of substrate portion models until a stopping criterion is met. These steps comprise 1. selecting a candidate basis function from a plurality of candidate basis functions; 2. updating the substrate portion model by adding the candidate basis function into the substrate portion model; 3. evaluating the updated substrate portion model using the measurement data; and 4. determining whether to include the basis function within the substrate portion model based on the evaluation.

## Description

### FIELD

The present disclosure relates to processing of substrates for the production of, for example, semiconductor devices.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use radiation. The wavelength of this radiation determines the minimum size of features which can be formed on the substrate. Typical wavelengths currently in use are about 365 nm (i-line), about 248 nm, about 193 nm and about 13 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of about 193 nm.

Low-kl lithography may be used to process features with dimensions smaller than the classical resolution limit of a lithographic apparatus. In such a process, the resolution formula may be expressed as CD = k1×λ/NA, where λ is the wavelength of radiation employed, NA is the numerical aperture of the projection optics in the lithographic apparatus, CD is the "critical dimension" (generally the smallest feature size printed, but in this case half-pitch) and k1 is an empirical resolution factor. In general, the smaller k1 the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of a numerical aperture (NA,) a customized illumination scheme, use of one or more phase shifting patterning devices, optimization of the design layout such as optical proximity correction (OPC) in the design layout, or other methods generally defined as resolution enhancement techniques (RET). Additionally or alternatively, one or more tight control loops for controlling a stability of the lithographic apparatus may be used to improve reproduction of the pattern at low k1.

Effectiveness of the control of a lithographic apparatus may depend on characteristics of individual substrates. For example, a first substrate processed by a first processing tool prior to processing by the lithographic apparatus (or any other process step of the manufacturing process, herein referred to generically as a manufacturing process step) may benefit from (slightly) different control parameters than a second substrate processed by a second processing tool prior to processing by the lithographic apparatus.

The accurate placement of patterns on the substrate is a chief challenge for reducing the size of circuit components and other products that may be produced by lithography. In particular, the challenge of measuring accurately the features on a substrate which have already been laid down is a critical step in being able to align successive layers of features in superposition accurately enough to produce working devices with a high yield. So-called overlay should, in general, be achieved within a few tens of nanometers in today's sub-micron semiconductor devices, down to a few nanometers in the most critical layers.

Consequently, modern lithography apparatuses involve extensive measurement or 'mapping' operations prior to the step of actually exposing or otherwise patterning the substrate at a target location. So-called advanced alignment models have been and continue to be developed to model and correct more accurately non-linear distortions of the wafer 'grid' that are caused by processing steps and/or by the lithographic apparatus itself. Not all distortions are correctable during exposure, however, and it remains important to trace and eliminate as many causes of such distortions as possible.

These distortions of the wafer grid are represented by measurement data associated with mark position. The measurement data are obtained from measurements of wafers. An example of such measurements are alignment measurements of alignment marks performed using an alignment system in a lithographic apparatus prior to exposure.

Furthermore, subsequent to exposure/processing, other parameters of interest such as overlay may be measured to monitor the performance and accuracy of the manufacturing process. For example, the measured values may be compared to an expected or target/desired value to determine an error value, based on which a correction may be determined for correcting a subsequent exposure, wafer or lot.

In both pre-exposure or pre-processing metrology (e.g., alignment) and post-exposure or post-processing metrology (e.g., overlay), the measurement data may be represented as a model in terms of a number of model parameters.

It would be desirable to improve modeling of such metrology data.

### SUMMARY

In a first aspect of the invention there is provided a method for modeling measurement data relating to a parameter of interest over at least two substrate portions of a substrate, comprising:
obtaining said measurement data;
obtaining a plurality of substrate portion models comprising at least a first substrate portion model for describing the parameter of interest across one or more first substrate portions on the substrate and a second substrate portion model for describing the parameter of interest across one or more second substrate portions on the substrate, the one or more first substrate portions and the second one or more substrate portions being different substrate portions; and
performing steps 1 to 4 iteratively for each of said plurality of substrate portion models until a stopping criterion is met, said steps comprising:
   **1.** selecting a candidate basis function from a plurality of candidate basis functions;
   **2.** updating the substrate portion model by adding the candidate basis function into the substrate portion model;
   **3.** evaluating the updated substrate portion model using the measurement data; and
   **4.** determining whether to include the basis function within the substrate portion model based on the evaluation

In a further aspect of the invention, there is provided a computer program comprising program instructions operable to perform the method of the first aspect when run on a suitable apparatus, and associated processing apparatus and lithographic and metrology apparatuses.

### BRIEF DESCRIPTION OF THE DRAWINGS

Embodiments of the invention will now be described, by way of example only, with reference to the accompanying schematic drawings, in which:
Figure 1 depicts a schematic overview of a lithographic apparatus;
Figure 2 depicts a schematic overview of a lithographic cell;
Figure 3 shows schematically the use of the lithographic apparatus and lithographic cell of Figures 1 and 2 together with one or more other apparatuses forming a manufacturing facility for, e.g., semiconductor devices, the facility implementing a control strategy according to an embodiment of the invention; and
Figure 4 is a flowchart describing a method according to an embodiment of the invention.

### DETAILED DESCRIPTION

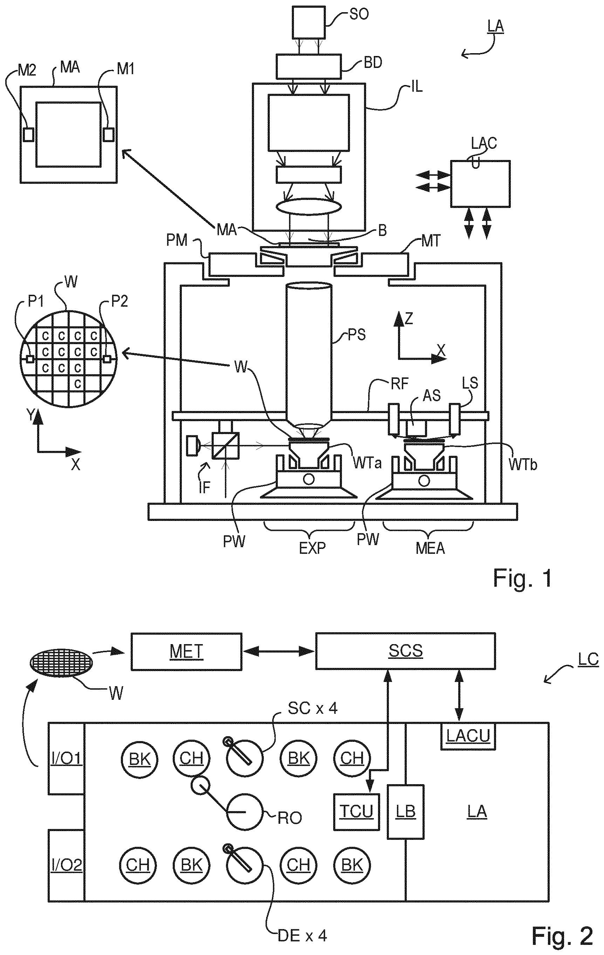

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a support (e.g., a mask table) T constructed to support a patterning device (e.g., a mask) MA and connected to a first positioner PM configured to accurately position the patterning device MA in accordance with certain parameters, one or more substrate supports (e.g., a wafer table) WTa and WTb constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in U.S. Patent No. 6,952,253, which is incorporated herein by reference.

Lithographic apparatus LA in this example is of a so-called dual stage type which has two substrate tables WTa and WTb and two stations - an exposure station and a measurement station-between which the substrate tables can be moved. While one substrate on one substrate table is being exposed at the exposure station EXP, another substrate can be loaded onto the other substrate table at, e.g., the measurement station MEA or at another location (not shown) or can be processed at measurement station MEA. A substrate table with a substrate can be located at measurement station MEA so that various preparatory steps may be carried out. The preparatory steps may include mapping the surface height of the substrate using a level sensor LS and/or measuring the position of alignment marks on the substrate using an alignment sensor AS. Due to inaccuracies in creating the marks and also due to deformations of the substrate that occur throughout its processing, the set of marks may next to translation and rotation have undergone more complex transformations. Consequently, in addition to measuring position and orientation of the substrate, the alignment sensor in practice may measure in detail the positions of many marks across the substrate area, if the apparatus LA is to print product features at the correct locations with high accuracy. The measurement of alignment marks can therefore be time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. An embodiment of the invention can be applied in an apparatus with only one substrate table, or with more than two.

In addition to having one or more substrate supports, the lithographic apparatus LA may comprise a measurement stage (not shown). The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

The radiation beam B is incident on the patterning device (e.g., mask) MA, which is held on the support structure (e.g., mask table) MT, and is patterned by the patterning device. Having traversed the patterning device MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WTa/WTb can be moved accurately, e.g. so as to position different target portions C in the path of the radiation beam B. Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WTa/WTb may be realized using a long-stroke module and a short-stroke module, which form part of the second positioner PW. In the case of a stepper (as opposed to a scanner) the support structure MT may be connected to a short-stroke actuator only, or may be fixed. Patterning device MA and substrate W may be aligned using patterning device alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device MA, the patterning device alignment marks may be located between the dies.

The apparatus further includes a lithographic apparatus control unit LACU which controls all the movements and measurements of various actuators and sensors of the lithographic apparatus (such as those described). Control unit LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus. For example, one processing subsystem may be dedicated to servo control of the substrate positioner PW. Separate units may even handle coarse and fine actuators, or different axes. Another unit might be dedicated to the readout of the position sensor IF. Overall control of the apparatus may be controlled by a central processing unit, communicating with these sub-systems processing units, with operators and with other apparatuses involved in the lithographic manufacturing process.

As shown in Figure 2 the lithographic apparatus LA may form part of a lithographic cell LC, also sometimes referred to as a lithocell or (litho)cluster, which often also includes apparatuses to perform pre- and post-exposure processes on a substrate W. Conventionally these apparatuses includes one or more spin coaters SC to deposit resist layers, one or more developers DE to develop exposed resist, one or more chill plates CH and one or more bake plates BK, e.g. for conditioning the temperature of substrates W e.g. for conditioning solvents in the resist layers. A substrate handler, or robot, RO picks up substrates W from input/output ports I/O1, I/O2, moves them between the different processing apparatuses and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, one or more inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus MET, which may also be referred to as a metrology apparatus or metrology tool, is used to determine one or more properties of the substrates W, and in particular, how one or more properties of different substrates W vary or how one or more properties associated with different layers of the same substrate W vary from layer to layer. The inspection apparatus may be constructed to identify defects on the substrate W and may, for example, be part of the lithocell LC, or may be integrated into the lithographic apparatus LA, or may even be a stand-alone device. The inspection apparatus may measure the one or more properties on a latent image (an image in a resist layer after the exposure), or on a semi-latent image (an image in a resist layer after a post-exposure bake step), or on a developed resist image (in which the exposed or unexposed parts of the resist have been removed), or even on an etched image (after a pattern transfer step such as etching).

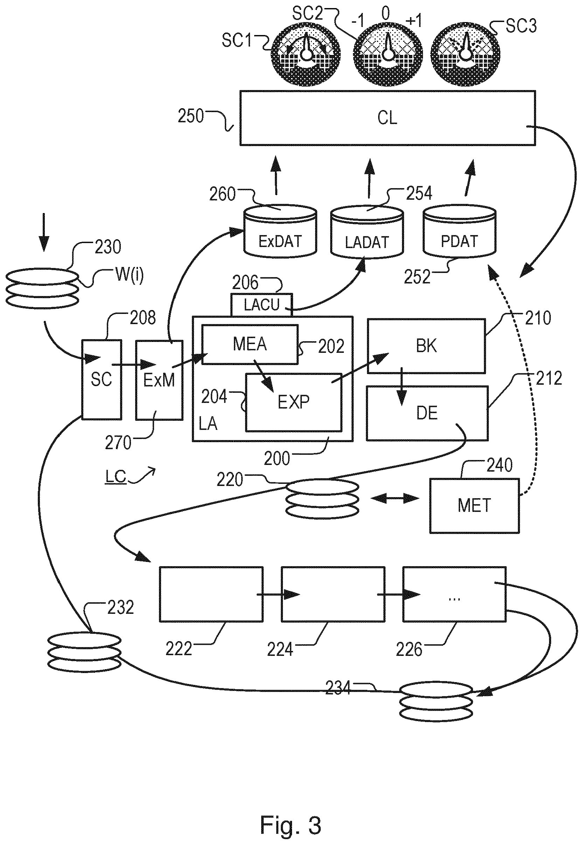

Figure 3 shows the lithographic apparatus LA and the lithocell LC in the context of an industrial manufacturing facility for, e.g., semiconductor products. Within the lithographic apparatus (or "litho tool" 200 for short), the measurement station MEA is shown at 202 and the exposure station EXP is shown at 204. The control unit LACU is shown at 206. As already described, litho tool 200 forms part of a "litho cell" or "litho cluster" that also includes a coating apparatus SC, 208 for applying photosensitive resist and/or one or more other coatings to substrate W for patterning by the apparatus 200. At the output side of apparatus 200, a baking apparatus BK, 210 and developing apparatus DE, 212 are provided for developing the exposed pattern into a physical resist pattern. Other components shown in Figure 3 are omitted, for clarity.

Once the pattern has been applied and developed, patterned substrates 220 are transferred to other processing apparatuses such as are illustrated at 222, 224, 226. A wide range of processing steps are implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses.

The described semiconductor manufacturing process comprising a sequence of patterning process steps is just one example of an industrial process in which the techniques disclosed herein may be applied. The semiconductor manufacturing process includes a series of patterning steps. Each patterning process step includes a patterning operation, for example a lithographic patterning operation, and a number of other chemical and/or physical operations.

The manufacture of semiconductor devices involves many repetitions of such processing, to build up device structures with appropriate materials and patterns, layer-by-layer on the substrate. Modern device manufacturing processes may comprise 40 or 50 individual patterning steps, for example. Accordingly, substrates 230 arriving at the litho cluster may be newly prepared substrates, or they may be substrates that have been processed previously in this cluster 232 or in another apparatus entirely. Similarly, depending on the required processing, substrates on leaving apparatus 226 may be returned for a subsequent patterning operation in the same litho cluster (such as substrates 232), they may be destined for patterning operations in a different cluster (such as substrates 234), or they may be finished products to be sent for dicing and packaging (such as substrates 234).

Each layer of the product structure typically involves a different set of process steps, and the apparatuses used at each layer may be completely different in type. Further, even where the processing steps to be applied by the apparatuses are nominally the same, in a large facility, there may be several supposedly identical machines working in parallel to perform the processing on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. Parallel processing may also be performed in different chambers within a larger apparatus. Moreover, in practice, different layers often involve different etch processes, for example chemical etch, plasma etch, etc., according to the details of the material to be etched, and special requirements such as, for example, anisotropic etching.

The previous and/or subsequent processes may be performed in other lithography apparatuses, as just mentioned, and may even be performed in different types of lithography apparatus. For example, one or more layers in the device manufacturing process which are very demanding in terms of, e.g., resolution and/or overlay may be performed in a more advanced lithography tool than one or more other layers that are less demanding. Therefore, one or more layers may be exposed in an immersion type lithography tool, while one or more others are exposed in a 'dry' tool. One or more layers may be exposed in a tool working at DUV wavelengths, while one or more others are exposed using EUV wavelength radiation.

Also shown in Figure 3 is the metrology apparatus (MET) 240 which is provided for making measurements of parameters of the products at desired stages in the manufacturing process. A common example of a metrology station in a modern lithographic manufacturing facility is a scatterometer, for example an angle-resolved scatterometer or a spectroscopic scatterometer, and it may be applied to measure one or more properties of developed substrates at 220 prior to etching in the apparatus 222. Using metrology apparatus 240, performance parameter data PDAT 252 may be determined. From this performance parameter data PDAT 252, it may be further determined that a performance parameter, such as overlay or critical dimension (CD), does not meet specified accuracy requirements in the developed resist. Prior to the etching step, the opportunity exists to strip the developed resist and reprocess one or more of the substrates 220 through the litho cluster. Moreover, the metrology results from the metrology apparatus 240 can be used to maintain accurate performance of the patterning operations in the litho cluster, by making small adjustments over time, thereby reducing or minimizing the risk of products being made out-of-specification, and requiring re-work. Of course, metrology apparatus 240 and/or one or more other metrology apparatuses (not shown) can be applied to measure one or more properties of the processed substrates 232, 234, and/or of incoming substrates 230.

Typically the patterning process in a lithographic apparatus LA is one of the most significant steps in the processing which involves high accuracy of dimensioning and placement of structures on the substrate W. To help ensure this high accuracy, three systems may be combined in a control environment as schematically depicted in Figure 3. One of these systems is the litho tool 200 which is (virtually) connected to a metrology apparatus 240 (a second system) and to a computer system CL 250 (a third system). A desire of such an environment is to optimize or improve the cooperation between these three systems to enhance an overall so-called "process window" and provide one or more tight control loops to help ensure that the patterning performed by the lithographic apparatus LA stays within a process window. The process window defines a range of values of a plurality of process parameters (e.g. two or more selected from dose, focus, overlay, etc.) within which a specific manufacturing process yields a defined result (e.g. a functional semiconductor device) - typically a range within which the values of the process parameters in the lithographic process or patterning process are allowed to vary while yielding a proper structure (e.g., specified in terms of an acceptable range of CD (such as +- 10% of a nominal CD)).

The computer system CL may use (part of) the design layout to be patterned to predict which one or more resolution enhancement techniques to use and to perform computational lithography simulations and calculations to determine which patterning device layout and lithographic apparatus settings achieve a largest overall process window of the patterning process (depicted in Figure 3 by the double arrow in the first dial SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second dial SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third dial SC3).

Computer system 250 can implement control of the process based on a combination of (i) "pre-processing metrology data" (e.g., including scanner metrology data LADAT 254, and External pre-processing metrology ExDAT 260), associated with substrates before they are processed in a given processing step (for example a lithography step) and (ii) performance data or "post-processing data" PDAT 252 that is associated with the substrates after they have been processed.

A first set of pre-processing metrology data LADAT 254 (referred to herein as scanner metrology data, as it is data generated by the lithographic apparatus LA 200 or scanner) may comprise the alignment data conventionally obtained by the lithographic apparatus LA 200 using alignment sensor AS in the measurement station 202. Alternatively, or in addition to the alignment data, the scanner metrology data LADAT 254 may include height data obtained using level sensor LS, and/or "wafer quality" signals from the alignment sensor AS or the like. As such, the scanner metrology data LADAT 254 may comprise an alignment grid for the substrate, and data relating to substrate deformation (flatness). For example, the scanner metrology data LADAT 254 may be generated by the measurement station MEA 202 of twin stage lithographic apparatus LA 200 (e.g., as this typically comprises the alignment sensor and leveling sensor) in advance of exposure, enabling simultaneous measurement and exposure operations. Such twin stage lithographic apparatus are well known.

Increasingly, (e.g. stand-alone) external pre-exposure metrology tools ExM 270 are used to make measurements before exposure on a lithographic apparatus. Such external pre-exposure metrology tools ExM 270 are distinct from the measurement station MEA 202 of a twin stage lithographic apparatus LA 200. Any pre-exposure measurements performed within the track are also considered to be external measurements. To maintain exposure throughput at a sufficient level, the scanner metrology data LADAT (e.g., alignment grid and substrate deformation grid) measured by measurement station MEA 202 is based on a sparser set of measurements as would be desirable. This typically means such a measurement station is incapable of gathering sufficient measurement data for higher order corrections, and particularly corrections beyond the third order. In addition to this, use of an opaque hard mask can make it difficult to accurately measure the wafer grid in alignment.

External pre-exposure metrology tools ExM 270 enable much denser measurements to be made on each substrate, prior to exposure. Some of these pre-exposure metrology tools ExM 270 measure and/or predict wafer grid deformation at a throughput equal to or faster than the scanner, and with a measurement density much higher than can be achieved using an alignment sensor and level sensor, even when such sensors are comprised within a separate measurement station MEA 202. Pre-exposure metrology tools comprise, for example, substrate shape inspection tools and/or stand-alone alignment stations.

While Figure 3 shows separate storage 252, 254, 260 for each of the performance data PDAT, scanner metrology data LADAT and external pre-exposure data ExDAT, it will be appreciated that these different types of data may be stored in one common storage unit, or may be distributed over a larger number of storage units, from which particular items of data can be retrieved when required.

To represent metrology data over a substrate (wafer) or a portion thereof (e.g., over a field) a model is typically used. For example, alignment measurements over a wafer and/or over a field are typically represented by an alignment model. Similarly, overlay measurements or overlay fingerprints are typically represented by an overlay model. A first purpose of a model is to provide a mechanism for interpolating and/or extrapolating the available measurements data over the area modeled (e.g., a whole wafer or whole field), such that an expose grid can be created on each exposure field and/or a correction determined for the wafer and/or field. The measurement data will be sparse as it is simply not practical to measure as many measurement regions as would be desirable from an overlay accuracy perspective: the time and therefore throughput overhead would be too high. A second purpose of such a model is to provide noise suppression. This may be achieved by using fewer model parameters than measurements or by using regularization. As such, reducing the number of model parameters is beneficial provided that the model still represents the data sufficiently well.

The main challenge in estimating a model for a given dataset is to find the right balance between capturing systematic disturbances and noise suppression. Roughly speaking, the shapes and complexity of a model should match the to-be-modeled data and the corresponding measurement layout. Estimation algorithms typically rely on a pre-selected model, which is often not optimal for the given dataset and the corresponding layout. To address this, it is known to use model parameter selection algorithms which aim to optimize a model for a given dataset. Different parameter selection techniques may select different parameters. Hence, effectiveness of a parameter selection technique may vary from dataset to dataset.

Therefore, to obtain a more accurate fingerprint (a spatial representation of data across a wafer or part thereof such as a field), model parameter selection techniques may be applied to fields having missing measurements such as edge fields or inner fields with invalidated measurement points. Existing model parameter selection techniques used for that purpose include projection ratio based model parameter reduction and layout based parameter reduction.

Projection ratio based model parameter reduction uses projection ratio to detect dependency or near-dependency caused by the combination of the sampling layout and the specific model which has been chosen to describe the observed/measured pattern. If a projection ratio corresponding to a model parameter is below a given threshold, then this parameter is removed from the model.

Current projection ratio based model parameter reduction techniques tend to result in underfitting or overfitting of the data for some use cases. For example, it may act too aggressively on the fields with invalid measurements or not aggressively enough to obtain an accurate estimation depending on the dataset. Reducing parameters too aggressively prevents estimation of a complete correctable overlay fingerprint. On the other hand, overfitting causes modelling of the noise in the dataset and leads to unrealistic overlay estimation. Both underfitting and overfitting results in higher on-product overlay on product wafers.

Layout based model parameter reduction uses a lookup table to select parameters based on the metrology layout. This approach was devised as an alternative to projection-ratio based model parameter reduction, to address specific estimation issues such as being too aggressive in parameter reduction at edge fields. However, layout based model parameter reduction proved to be highly dataset dependent. On certain datasets, where projection ratio based parameter reduction was shown to be problematic, layout based parameter reduction did indeed improve model accuracy and precision. However, this improvement is highly dependent on the dataset because of its strict design. Layout based model parameter reduction cannot adapt to the input measurements, hence may also overfit or underfit the data.

Both projection ratio based and layout based parameter reduction methods act solely on the layout of the measurements. Measurement values (i.e., the actual measurement data) do not have any effect on the parameter selection. Therefore, existing parameter reduction methods cannot take into account the significance of the measurement data and as a result disregard valuable information.

It is therefore proposed to provide a method which supports the automatic selection of most promising parameters based on how well each parameter describes the data (both layout and value), given any model. Such a method may comprise an enhanced model uncertainty based parameter selection. In an embodiment, the method may employ an Orthogonal Matching Pursuit (OMP) based algorithm to select parameters. In one or more embodiments, the proposed method may use one or more of: regularization, a model uncertainty metric (e.g., normalized model uncertainty nMU) based stopping criteria and benefit/cost ratio based basis function selection. nMU describes a noise-to-model uncertainty application factor.

The concepts disclosed herein will be described in the context of modeling over substrate portions, wherein a substrate portion comprises a region or an area of the substrate, such as an exposure field or a die portion. In particular, the method provides for separate modeling of at least two said substrate portions. The method will be described largely in terms of field modeling (i.e., each substrate portion is an exposure field); however the application is not so limited and any disclosure of field in the foregoing description may be understood to include (or may be replaced by) other, non-field substrate portions. Such non-field substrate portions may be on a spatial scale smaller than a field (e.g., per die or functional area within an exposure field), or a spatial scale larger than a field (for example the substrate may be divided into two or more separate portions for which separate modeling may be beneficial. One such example may comprise dividing the substrate into two (or more) portions comprising: a first substrate portion comprising a central area of a substrate and a second substrate portion comprising a peripheral or outer portion of the substrate. Where the substrate is divided into more than two substrate portions (e.g., according to exposure fields or otherwise), separate models may be devised for each portion or group of portions according to where the fields/portions are on the substrate (e.g., according to distance from the center).

In an embodiment, such a method may comprise determining; by performing the following steps:
**1.** obtaining measurement data relating to a parameter of interest on a substrate;
**2.** obtaining at least two substrate portion models for describing a performance parameter across a respective substrate portion or respective groups thereof on a substrate; and, for each of said at least two substrate portion models:
**3.** selecting a basis function from a plurality of candidate basis functions;
**4.** updating the substrate portion model by adding the basis function into the substrate portion model;
**5.** evaluating the updated substrate portion model using the measurement data;
**6.** determining whether to include the basis function within the substrate portion model based on the evaluation; and
**7.** repeating steps 3 to 6 for iteratively for a different basis function in each iteration, the iterations continuing until a stopping criterion is met;
wherein the at least two substrate portion models comprises at least a first substrate portion model for describing the performance parameter across one or more first substrate portions on the substrate and a second substrate portion model for describing the performance parameter across one or more second substrate portions on the substrate, the first substrate portion and the second substrate portion being different substrate portions to each other.

The method may comprise generating a first process control signal for the first substrate portion(s) using the first substrate portion model, and generating a second process control signal for the second substrate portion(s) using the second substrate portion model.

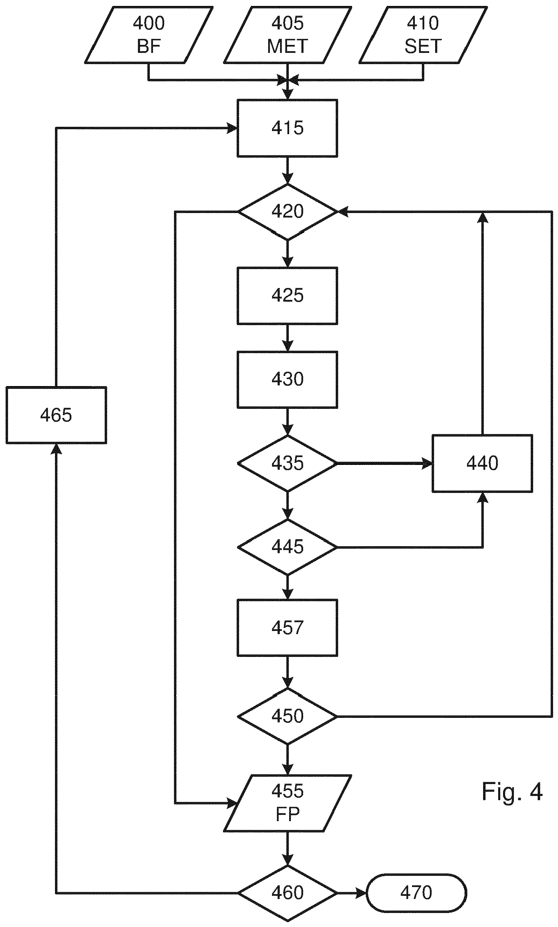

Figure 4 is a flowchart describing the invention in an embodiment. Initial data may comprise a dictionary of candidate or available basis functions and associated model parameters 400 (basis functions are mathematical functions, whereas model parameters are the coefficients with which these mathematical functions are multiplied to obtain a model; there is a 1:1 correspondence such that each basis function has a corresponding parameter), measurement data 405 and settings data 410. At step 415 is an initialization step for (initially) a first model is performed. This may comprise setting the parameter list based on the measurement data and a (e.g., baseline) fingerprint model to be applied. The selected parameter list may depend on the availability of measurement data for either one or both of the overlay directions. This step may also comprise initializing the algorithm with a solution for the zero order basis functions. These zero order basis functions or translations may be calculated using conventional methods, without a regularization term (term is equal to zero). In this step, an evaluation grid may be constructed from one or more of: an uncertainty limit or nMU limit, grid resolution, residual tolerance (i.e., the noise level/limit used at step 435) and edge clearance (which may define the evaluation grid as not comprising any points within and 'edge clearance' distance from the wafer edge) to initialize an iterative computation.

The algorithm is an iterative process where the latest residuals, nMU and a selection of parameters/basis functions are tracked over the iterations. In each iteration (per model) it is determined whether adding a basis function is beneficial and which basis function should be selected for the model. At step 420, a benefit metric for each basis function is calculated. The benefit metric may comprise an indication or evaluation as to how well the residuals (residual metric), obtained at the previous iteration at step 430 or in the initialization step 415 for the first iteration, can be fitted. This step may comprise, for a current iteration, calculating the benefit of each basis function/parameter as the correlation between the residuals and each basis function or parameter, evaluated on the same grid of the residuals. The correlation may comprise the sum of elements of the element-wise multiplication of the vector of residuals and the vector of the evaluated basis function/parameter in the grid. Mathematically this is also known as the inner product of the vector of residuals and vector of the evaluated basis function.

An associated cost metric for each basis function may be calculated (as part of this step or the next step); e.g., based on a wildness metric for the basis function. In this context, the wildness of a function may comprise a measurement of how much the basis function varies over the wafer, e.g., a basis function which describes a flat surface is less 'wild' than a basis function that describes an oscillating surface.

At step 425, the basis function with the highest associated benefit, or benefit/cost ratio, is chosen for the iteration and added to the model. If adding a basis function is deemed not beneficial at this step the final model or fingerprint 455 is determined and the next model considered (if there is one).

At step 430 it is determined whether the updated model solves the posed (e.g., regularized least square) problem. The regularization terms are determined, for example, according to an internal rule and the corresponding regularized least square problem is solved. The (optional) use of regularization ensures a more robust solution.

The residuals associated to this solution are calculated to obtain a residual metric and, at step 435, it is determined whether the residual metric is smaller than the limit (noise level) provided in the settings 410. If so, this parameter/basis function is discarded 440 to avoid over-fitting and another iteration begins. If it is higher than the limit, at step 445 the nMU is calculated on the evaluation grid. This may comprise determining whether the calculated nMU is not within the defined limit; if so, this parameter is discarded 440 and another iteration begins. If nMU is within the defined limit, the parameter considered in that iteration is selected 457 for the model and stored in memory. At 450 it is determined whether more candidate parameters are available. If not, the flow returns to step 420 for another iteration; if all parameters have been used, then the final model or fingerprint is determined 455 (e.g., for a first field/group of fields). At step 460, it is determined whether another model is to be determined, e.g., for a second field/group of fields. If so, the second model is selected 465 and the method returns to initiation step 415, performed using the candidate basis functions, measurement data and settings applicable to this new model. Once all models are determined the flow ends 470.

In this manner, this iterative algorithm selects the most useful parameters and how much to use them (with regularization). It avoids underfitting by selecting parameters from the parameter pool defined by the fingerprint model and using regularization to define weights to each parameter. It also avoids overfitting by selecting the parameters according to nMU limit and residual tolerance defined in the settings.

In an embodiment, the parameters or basis functions may be ranked (per model) based on their corresponding performance indicators (e.g., the determined nMU and/or residuals determined in the algorithm). The list of ranked model parameters may indicate which (e.g., higher order) model parameters (e.g., k-parameters) are best suited to model the data used as correction parameters for overlay correction or to model alignment data, for example.

This parameter selection method can be used with both per-field or per-substrate portion and is applicable to any kind of modeling such as overlay, focus and critical dimension.

Further embodiments may be described in the following clauses:
1. A method for determining models for describing measurement data relating to a parameter of interest over at least two substrate portions of a substrate, comprising:
   obtaining said measurement data;
   obtaining a plurality of substrate portion models comprising at least a first substrate portion model for describing the parameter of interest across one or more first substrate portions on
   the substrate and a second substrate portion model for describing the parameter of interest across one or more second substrate portions on the substrate, the one or more first substrate portions and the second one or more substrate portions being different substrate portions; and performing steps 1 to 4 iteratively for each of said plurality of substrate portion models until a stopping criterion is met, said steps comprising:
      1. selecting a candidate basis function from a plurality of candidate basis functions;
      2. updating the substrate portion model by adding the candidate basis function into the substrate portion model;
      3. evaluating the updated substrate portion model using the measurement data; and
      4. determining whether to include the basis function within the substrate portion model based on the evaluation.
2. A method according to clause 1, wherein the one or more first substrate portions comprise one or more first exposure fields and said one or more second substrate portions comprise one or more second exposure fields.
3. A method according to clause 1 or 2, wherein said first one or more first substrate portions are located within a central area of said substrate and said second one or more second substrate portions are located outside of said central area of said substrate.
4. A method according to any preceding clause, wherein said steps 1 to 4 employ an Orthogonal Matching Pursuit based algorithm to select said basis functions.
5. A method according to any preceding clause, wherein step 3 comprises performing a fit of the measurement data based on the updated substrate portion model obtained in step 2 to determine a residual metric.
6. A method according to clause 5, wherein step 3 comprises determining whether the substrate portion model solves a regularized least square problem related to the fitting.
7. A method according to clause 5 or 6, wherein step 3 comprises comparing the residual metric to a residual threshold limit; and
   rejecting the associated candidate basis function from the respective substrate portion model if the residual metric is below the residual threshold limit.
8. A method according to clause 7, wherein the residual threshold limit is based on a noise level related to the measurement data.
9. A method according to any of clause 5 to 8, comprising determining at least a benefit metric for a basis function evaluated in each iteration, said benefit metric quantifying a benefit of including the basis function in the model.
10. A method according to clause 9, wherein the benefit metric comprises an evaluation as to how well the residual metric, obtained at the previous iteration at step 3 or in an initialization step for the first iteration, can be fitted.
11. A method according to clause 10, wherein the benefit metric comprises a benefit/cost metric having an associated cost associated with the basis function.
12. A method according to clause 11, wherein the cost metric comprises a wildness metric comprising a measure of how much the basis function varies over the substrate.
13. A method according to any of clause 9 to 12, comprising selecting the basis function with the highest associated benefit metric or benefit/cost metric in each iteration.
14. A method according to any preceding clause, wherein step 4 is based on a model uncertainty metric.
15. A method according to clause 14, wherein said model uncertainty metric comprises normalized model uncertainty.
16. A method according to clause 14 or 15, wherein step 4 comprises:
   determining the model uncertainty metric;
   comparing the model uncertainty metric to a model uncertainty threshold limit; and
   rejecting the associated candidate basis function from the respective substrate portion model if the model uncertainty metric is above the model uncertainty threshold limit.
17. A method according to any preceding clause, comprising for each substrate portion model, an initial step of determining said plurality of candidate basis functions based on said measurement data and a baseline substrate portion model.
18. A method according to clause 17, wherein said initial step further comprises determining an evaluation grid for performing said evaluating at step 3, from one or more of: said model uncertainty metric, grid resolution, residual tolerance and edge clearance.
19. A method according to any preceding clause, comprising a final step per substrate portion model of ranking said basis functions based on the evaluations performed at step 3.
20. A method according to any preceding clause, comprising generating a first process control signal for the first substrate portion(s) using the first substrate portion model, and generating a second process control signal for the second substrate portion(s) using the second substrate portion model.
21. A method according to any preceding clause, wherein:
   said measurement data comprises alignment data and the parameter of interest is a measured position; or
   said measurement data comprises overlay data and the parameter of interest is overlay.
22. A method according to any preceding clause, comprising measuring said substrate to obtain said measurement data.
23. A computer program comprising program instructions operable to perform the method of any preceding clause, when run on a suitable apparatus.
24. A non-transient computer program carrier comprising the computer program of clause 23.
25. A processing arrangement comprising:
   the non-transient computer program carrier of clause 24; and
   a processor operable to run the computer program comprised on said non-transient computer program carrier.
26. A lithographic apparatus comprising:
   an alignment sensor;
   a patterning device support for supporting a patterning device;
   a substrate support for supporting a substrate; and
   the processing arrangement of clause 25.
27. A lithographic apparatus according to clause 26, wherein the alignment sensor is operable to measure the substrate to obtain said measurement data.
28. A lithographic apparatus according to clause 27 or 28, wherein the processing arrangement is further operable to determine corrections for control said patterning device and/or substrate support based on the determined plurality of substrate portion models.
29. A metrology apparatus comprising the processing arrangement of clause 25.
30. A metrology apparatus according to clause 29, comprising a scatterometer or microscope metrology device.
31. A lithographic system comprising the metrology device of clause 29 or 30 and the lithographic apparatus of any of clause 26 to 28, being operable to use said plurality of substrate portion models to model measurement data measured by said metrology device.
32. A lithographic system according to clause 31, being operable to determine corrections for said lithographic apparatus based on said measurement data as modeled.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.. In that regard, the processed "substrates" may be semiconductor wafers, or they may be other substrates, according to the type of product being manufactured.

Although specific reference may be made in this text to embodiments of the invention in the context of a lithographic apparatus, embodiments of the invention may be used in other apparatus. Embodiments of the invention may form part of a patterning device inspection apparatus, a metrology apparatus, or any apparatus that measures or processes an object such as a wafer (or other substrate) or a mask (or other patterning device). These apparatuses may be generally referred to as lithographic tools. Such a lithographic tool may use vacuum conditions or ambient (non-vacuum) conditions.

In the present document, the terms "radiation" and "beam" are used to encompass all types of radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

Although specific reference may have been made above to the use of embodiments of the invention in the context of optical lithography, it will be appreciated that the invention, where the context allows, is not limited to optical lithography and may be used in other applications, for example imprint lithography.

The terms "optimizing" and "optimization" as used herein refers to or means adjusting an apparatus (e.g., a lithography apparatus), a process, etc. such that results and/or processes have more desirable characteristics, such as higher accuracy of projection of a design pattern on a substrate, a larger process window, etc. Thus, the term "optimizing" and "optimization" as used herein refers to or means a process that identifies one or more values for one or more parameters that provide an improvement, e.g. a local optimum, in at least one relevant metric, compared to an initial set of one or more values for those one or more parameters. "Optimum" and other related terms should be construed accordingly. In an embodiment, optimization steps can be applied iteratively to provide further improvements in one or more metrics.

Aspects of the invention can be implemented in any convenient form. For example, an embodiment may be implemented by one or more appropriate computer programs which may be carried on an appropriate carrier medium which may be a tangible carrier medium (e.g. a disk) or an intangible carrier medium (e.g. a communications signal). Embodiments of the invention may be implemented using suitable apparatus which may specifically take the form of a programmable computer running a computer program arranged to implement a method as described herein.

In block diagrams, illustrated components are depicted as discrete functional blocks, but embodiments are not limited to systems in which the functionality described herein is organized as illustrated. The functionality provided by each of the components may be provided by software or hardware modules that are differently organized than is presently depicted, for example such software or hardware may be intermingled, conjoined, replicated, broken up, distributed (e.g. within a data center or geographically), or otherwise differently organized. The functionality described herein may be provided by one or more processors of one or more computers executing code stored on a tangible, non-transitory, machine readable medium. In some cases, third party content delivery networks may host some or all of the information conveyed over networks, in which case, to the extent information (e.g., content) is said to be supplied or otherwise provided, the information may be provided by sending instructions to retrieve that information from a content delivery network.

Unless specifically stated otherwise, as apparent from the discussion, it is appreciated that throughout this specification discussions utilizing terms such as "processing," "computing," "calculating," "determining" or the like refer to actions or processes of a specific apparatus, such as a special purpose computer or a similar special purpose electronic processing/computing device.

The reader should appreciate that the present application describes several inventions. Rather than separating those inventions into multiple isolated patent applications, these inventions have been grouped into a single document because their related subject matter lends itself to economies in the application process. But the distinct advantages and aspects of such inventions should not be conflated. In some cases, embodiments address all of the deficiencies noted herein, but it should be understood that the inventions are independently useful, and some embodiments address only a subset of such problems or offer other, unmentioned benefits that will be apparent to those of skill in the art reviewing the present disclosure. Due to costs constraints, some inventions disclosed herein may not be presently claimed and may be claimed in later filings, such as continuation applications or by amending the present claims. Similarly, due to space constraints, neither the Abstract nor the Summary sections of the present document should be taken as containing a comprehensive listing of all such inventions or all aspects of such inventions.

It should be understood that the description and the drawings are not intended to limit the present disclosure to the particular form disclosed, but to the contrary, the intention is to cover all modifications, equivalents, and alternatives falling within the spirit and scope of the inventions as defined by the appended claims.

Modifications and alternative embodiments of various aspects of the inventions will be apparent to those skilled in the art in view of this description. Accordingly, this description and the drawings are to be construed as illustrative only and are for the purpose of teaching those skilled in the art the general manner of carrying out the inventions. It is to be understood that the forms of the inventions shown and described herein are to be taken as examples of embodiments. Elements and materials may be substituted for those illustrated and described herein, parts and processes may be reversed or omitted, certain features may be utilized independently, and embodiments or features of embodiments may be combined, all as would be apparent to one skilled in the art after having the benefit of this description. Changes may be made in the elements described herein without departing from the spirit and scope of the invention as described in the following claims. Headings used herein are for organizational purposes only and are not meant to be used to limit the scope of the description.

As used throughout this application, the word "may" is used in a permissive sense (i.e., meaning having the potential to), rather than the mandatory sense (i.e., meaning must). The words "include", "including", and "includes" and the like mean including, but not limited to. As used throughout this application, the singular forms "a," "an," and "the" include plural referents unless the content explicitly indicates otherwise. Thus, for example, reference to "an" element or "a" element includes a combination of two or more elements, notwithstanding use of other terms and phrases for one or more elements, such as "one or more." The term "or" is, unless indicated otherwise, non-exclusive, i.e., encompassing both "and" and "or." Terms describing conditional relationships, e.g., "in response to X, Y," "upon X, Y,", "if X, Y," "when X, Y," and the like, encompass causal relationships in which the antecedent is a necessary causal condition, the antecedent is a sufficient causal condition, or the antecedent is a contributory causal condition of the consequent, e.g., "state X occurs upon condition Y obtaining" is generic to "X occurs solely upon Y" and "X occurs upon Y and Z." Such conditional relationships are not limited to consequences that instantly follow the antecedent obtaining, as some consequences may be delayed, and in conditional statements, antecedents are connected to their consequents, e.g., the antecedent is relevant to the likelihood of the consequent occurring. Statements in which a plurality of attributes or functions are mapped to a plurality of objects (e.g., one or more processors performing steps A, B, C, and D) encompasses both all such attributes or functions being mapped to all such objects and subsets of the attributes or functions being mapped to subsets of the attributes or functions (e.g., both all processors each performing steps A-D, and a case in which processor 1 performs step A, processor 2 performs step B and part of step C, and processor 3 performs part of step C and step D), unless otherwise indicated. Further, unless otherwise indicated, statements that one value or action is "based on" another condition or value encompass both instances in which the condition or value is the sole factor and instances in which the condition or value is one factor among a plurality of factors. Unless otherwise indicated, statements that "each" instance of some collection have some property should not be read to exclude cases where some otherwise identical or similar members of a larger collection do not have the property, i.e., each does not necessarily mean each and every. References to selection from a range includes the end points of the range.

In the above description, any processes, descriptions or blocks in flowcharts should be understood as representing modules, segments or portions of code which include one or more executable instructions for implementing specific logical functions or steps in the process, and alternate implementations are included within the scope of the exemplary embodiments of the present advancements in which functions can be executed out of order from that shown or discussed, including substantially concurrently or in reverse order, depending upon the functionality involved, as would be understood by those skilled in the art.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method for determining models for describing measurement data relating to a parameter of interest over at least two substrate portions of a substrate, comprising:
obtaining said measurement data;
obtaining a plurality of substrate portion models comprising at least a first substrate portion model for describing the parameter of interest across one or more first substrate portions on the substrate and a second substrate portion model for describing the parameter of interest across one or more second substrate portions on the substrate, the one or more first substrate portions and the second one or more substrate portions being different substrate portions; and
performing steps 1 to 4 iteratively for each of said plurality of substrate portion models until a stopping criterion is met, said steps comprising:
1. selecting a candidate basis function from a plurality of candidate basis functions;
2. updating the substrate portion model by adding the candidate basis function into the substrate portion model;
3. evaluating the updated substrate portion model using the measurement data; and
4. determining whether to include the basis function within the substrate portion model based on the evaluation.

2. A method as claimed in claim 1, wherein the one or more first substrate portions comprise one or more first exposure fields and said one or more second substrate portions comprise one or more second exposure fields.

3. A method as claimed in claim 1 or 2, wherein said first one or more first substrate portions are located within a central area of said substrate and said second one or more second substrate portions are located outside of said central area of said substrate.

4. A method as claimed in any preceding claim, wherein step 3 comprises performing a fit of the measurement data based on the updated substrate portion model obtained in step 2 to determine a residual metric.

5. A method as claimed in claim 4, wherein step 3 comprises comparing the residual metric to a residual threshold limit; and
rejecting the associated candidate basis function from the respective substrate portion model if the residual metric is below the residual threshold limit.

6. A method as claimed in claim 4 or 5, comprising determining at least a benefit metric for a basis function evaluated in each iteration, said benefit metric quantifying a benefit of including the basis function in the model.

7. A method as claimed in claim 6, wherein the benefit metric comprises a benefit/cost metric having an associated cost associated with the basis function.

8. A method as claimed in any preceding claim, wherein step 4 is based on a model uncertainty metric.

9. A method as claimed in claim 8, wherein step 4 comprises:
determining the model uncertainty metric;
comparing the model uncertainty metric to a model uncertainty threshold limit; and
rejecting the associated candidate basis function from the respective substrate portion model if the model uncertainty metric is above the model uncertainty threshold limit.

10. A method as claimed in any preceding claim, comprising for each substrate portion model, an initial step of determining said plurality of candidate basis functions based on said measurement data and a baseline substrate portion model.

11. A method as claimed in any preceding claim, comprising a final step per substrate portion model of ranking said basis functions based on the evaluations performed at step 3.

12. A method as claimed in any preceding claim, comprising generating a first process control signal for the first substrate portion(s) using the first substrate portion model, and generating a second process control signal for the second substrate portion(s) using the second substrate portion model.

13. A computer program comprising program instructions operable to perform the method of any preceding claim, when run on a suitable apparatus.

14. A processing arrangement comprising:
the non-transient computer program carrier comprising the computer program of claim 13; and
a processor operable to run the computer program comprised on said non-transient computer program carrier.

15. A metrology apparatus comprising the processing arrangement of claim 14.
